# EUROPEAN PATENT SPECIFICATION

(11) **EP 2 890 226 B1**
(45) Date of publication and mention of the grant of the patent: **09.08.2017**
(21) Application number: 13831045.3
(22) Date of filing: 23.08.2013
(51) Int. Cl.: H05K 1/18, H05K 3/30, H01R 12/70

(54) **CONNECTION STRUCTURE FOR SUBSTRATE CONNECTOR AND CONNECTION METHOD**
VERBINDUNGSSTRUKTUR FÜR EINEN SUBSTRATVERBINDER UND VERBINDUNGSVERFAHREN
STRUCTURE DE RACCORDEMENT DESTINÉE À UN CONNECTEUR DE SUBSTRAT ET PROCÉDÉ DE RACCORDEMENT

(30) Priority: 24.08.2012 JP 2012185742
(43) Date of publication of application: 01.07.2015
(73) Proprietor: Yazaki Corporation, Minato-ku Tokyo 108-8333 (JP)
(72) Inventor: IKEDA Yukiyoshi, Susono-shi Shizuoka 410-1194 (JP)
(74) Representative: Grünecker Patent- und Rechtsanwälte PartG mbB
(86) International application number: PCT/JP2013/072552
(87) International publication number: WO 2014/030740

(56) References cited:
- DE-U1- 20 107 759
- GB-A- 1 534 730
- JP-A- H 046 768
- JP-A- H08 307 077
- JP-A- 2008 171 708
- JP-U- S4 953 286
- JP-U- S5 856 470
- JP-U- S5 856 470
- US-A- 6 095 856
- US-B1- 6 168 463
- US-B1- 6 364 700

## Description

### Technical Field

The present invention relates to a connection structure and a connection method of a board connector.

### Background Art

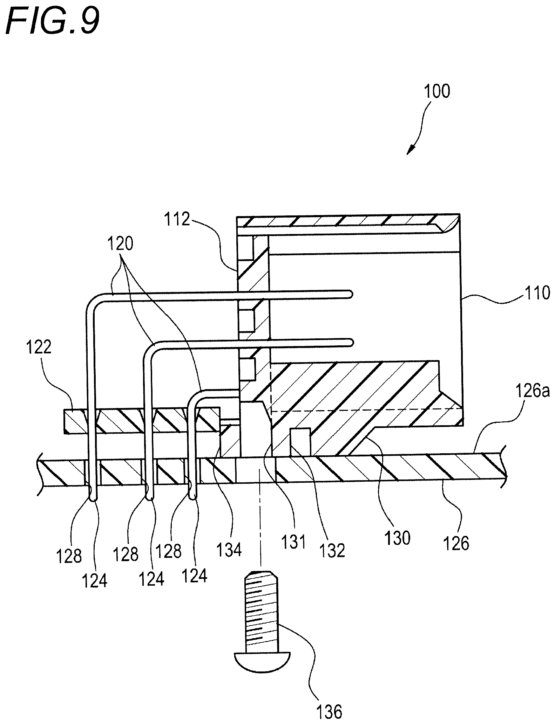

DE 201 07 759 U1 describes a connector strip which comprises several of contact elements and a fixing element. The fixing element comprises a lever arm and a fixing hook. Moreover, DE 201 07 759 U1 describes that the printed circuit board comprises several trough holes and a solder side. Patent Literature 1 described below discloses a connection structure of a board connector to a printed circuit board. US 6 364 700 B1 discloses a connection structure and a connection method according to the preambles of claims 1 and 2, respectively. FIG. 9 is a cross-sectional view illustrating a connection structure of a boarα connector to a printed circuit board, which is disclosed in Patent Literature 1.

Aboard connector 100 has a housing 110 that is formed substantially like a rectangular parallelepiped and made of a plastic such as PBT, plural rows of male terminals 120 fixed to the rear wall 112 of the housing 110, and a holding plate 122 that holds the male terminals 120 in an aligned state. One bent end portion of each male terminal 120 configures a soldering terminal 124. Each soldering terminal 124 is inserted through a through-hole 128 formed in a printed circuit board 126 and protrudes a predetermined amount from the bottom surface of the printed circuit board 126.

The housing 110 is formed integrally with a stand-off projection portion 130, and wall portions 132 and 134 for a screw hole 131. The board connector 100 is fixed to the printed circuit board 126 with a screw 136. Further, each soldering terminal 180 inserted through the through-hole 128 of the printed circuit board 126 and protruded from the printed circuit board 126 is electrically connected to a contact point pattern associated with the through-holes 128 by being soldered to the contact point pattern.

When the stand-off projection portion 130 and the wall portions 132 and 134 are attached to the printed circuit board 126, the tip ends of the stand-off projection portion 130 and the wall portions 132 and 134 abut on a surface 126a of the printed circuit board 126 to thereby ensure a gap between the printed circuit board 126 and the housing 110.

In the case of Patent Literature 1, soldering between each soldering terminal 124 and the associated through-hole 128 is performed by a flow method in which the printed circuit board 126 is flown on a solder bath containing liquid solder melted by being heated.

### Citation List

### Patent Literature

Patent Literature 1: JP-T-2002-508878

### Summary of Invention

### Technical Problem

Incidentally, if it is necessary to change the gap (stand-off value) between the housing 110 and the printed circuit board 126 in the connection structure of the board connector disclosed in Patent Literature 1, it is required to change the height of each of the stand-off projection portion 130 and the wall portions 132 and 134, which actually abut on the surface 126a of the printed circuit board 126.

In this case, if the same housing 110 is to be used, it is not straightforward to configure the stand-off projection portion 130 and the wall portions 132 and 134 to change the height to various values. Accordingly, it is necessary to preliminarily prepare various housings 110 respectively corresponding to which the stand-off projection portions 130 and the wall portions 132 and 134 have various heights.

Accordingly, a problem has occurred, in which it is not straightforward to cope with change in the gap (i.e., the stand-off value) between the board connector 100 and the printed circuit board 126 in preparation for diversifying the gap therebetween.

Further, in the connection structure of the board connector disclosed in Patent Literature 1, each soldering terminal 124 is inserted into the associated through-hole 128 from above the printed circuit board 126. Thus, for example, if solder paste is preliminarily charged into the through-holes 128 in order to perform soldering according to a reflow method, when the soldering terminals 124 are inserted through the through-holes 128, respectively, the solder paste charged into the through-holes 128 is dropped therefrom by an extruding action of the soldering terminals 124 themselves. Accordingly, solder paste is not sufficiently applied to the soldering terminals 128. Consequently, even when heating is performed to melt the solder paste, a connection failure occurs due to insufficiency of solder.

Thus, in the case of the connection structure of the board connector disclosed in Patent Literature 1, there have been drawbacks in that this connection structure is not suited to the soldering according to the reflow method and that the soldering method is limited to the flow method.

Accordingly, an object of the present invention is to solve the above drawbacks, and to provide a connection structure and a connection method of a board connector, which can easily cope with change in the gap between a housing body of the board connector and a printed circuit board, and which can satisfactorily conductively connect between the soldering terminals and the through-holes according to either a flow soldering method or a reflow soldering method.

### Solution to Problem

The above object of the present invention is achieved by the following configurations.
(1) A connection structure of a board connector to a printed circuit board, the board connector including:
   a soldering terminal configured to be soldered to a through-hole of the printed circuit board
   a housing body configured to hold the soldering terminal so that the soldering terminal protrudes from the printed circuit board a predetermined length;
   a stand-off projection portion provided on the housing body to protrude from the housing body, and configured to abut on the printed circuit board when the housing body is attached to the printed circuit board, to thereby ensure a gap between the printed circuit board and the housing body; and
   an elastic locking piece including a locking protrusion portion that protrudes in a direction orthogonal to a direction of thickness of the printed circuit board and is provided at a tip end of an elastic piece extending in the direction of thickness of the printed circuit board from the housing body, wherein the locking protrusion portion engages with a board-backsurface-side edge of a connector locking opening formed to penetrate through the printed circuit board and to allow the elastic piece to be inserted through the connector locking opening, thereby restricting the board connector from falling off the printed circuit board, wherein
   the board connector is put into a state in which the board connector is connected to the printed circuit board by engaging the elastic locking piece with the board-backsurface-side edge of the connector locking opening,
   a contact surface of the locking protrusion portion configured to be contacted with the board-backsurface-side edge of the connector locking opening is formed to be an inclined surface on which the printed circuit board moves in a direction in which the printed circuit board moves away from the board connector in a case where a diameter of the connector locking opening is increased, and
   the printed circuit board, whose thickness is set to be smaller than a separation distance between a base end of the contact surface and a tip end of the stand-off projection portion, is used, and also the diameter of the connector locking opening is set so that a protruding length of the soldering terminal from the through-hole is matched with a target value by contact between the board-backsurface-side edge of the connector locking opening and the contact surface.
(2) A connection method of a board connector to a printed circuit board, wherein,
   in a connection structure of the board connector, the board connector includes:
   a soldering terminal configured to be soldered to a through-hole of the printed circuit board;
   a housing body configured to hold the soldering terminal so that the soldering terminal protrudes from the printed circuit board a predetermined length;
   a stand-off projection portion provided on the housing body to protrude from the housing body, and configured to abut on the printed circuit board when the housing body is attached to the printed circuit board, to thereby ensure a gap between the printed circuit board and the housing body; and
   an elastic locking piece including a locking protrusion portion that protrudes in a direction orthogonal to a direction of thickness of the printed circuit board and is provided at a tip end of an elastic piece extending in the direction of thickness of the printed circuit board from the housing body, wherein the locking protrusion portion engages with a board-backsurface-side edge of a connector locking opening formed to penetrate through the printed circuit board and to allow the elastic piece to be inserted through the connector locking opening, thereby restricting the board connector from falling off the printed circuit board, wherein
   the board connector is put into a state in which the board connector is connected to the printed circuit board by engaging the elastic locking piece with the board-backsurface-side edge of the connector locking opening,
   a contact surface of the locking protrusion portion configured to be contacted with the board-backsurface-side edge of the connector locking opening is formed to be an inclined surface on which the printed circuit board moves in a direction in which the printed circuit board moves away from the board connector in a case where a diameter of the connector locking opening is increased, and
   the printed circuit board, whose thickness is set to be smaller than a separation distance between a base end of the contact surface and a tip end of the stand-off projection portion, is used, and also the diameter of the connector locking opening is set so that a protruding length of the soldering terminal from the through-hole is matched with a target value by contact between the board-backsurface-side edge of the connector locking opening and the contact surface, wherein
   connection between the printed circuit board and the board connector is performed in a direction in which the board connector hangs down from the printed circuit board, and
   the board connector and the printed circuit board are put into a connected state by soldering the soldering terminal to the through-hole according to a reflow method in which the through-hole is filled with solder paste before the soldering terminal is inserted through the through-hole.
(3) The connection method of the board connector according to the above configuration (2), wherein a stand-off value that indicates a size of the gap between the printed circuit board and the housing body is changed to a desired value by changing the diameter of the connector locking opening.

With the above configurations (1) and (2), the contact surface of the locking protrusion portion of the board connector contacted with the board-backsurface-side edge of the connector locking opening is formed to be an inclined surface on which the printed circuit board moves in a direction in which the printed circuit board moves away from the board connector when a diameter of the connector locking opening is increased. Thus, change in the gap between the housing body of the board connector and the printed circuit board can easily be coped with only by increasing or decreasing the diameter of the connector locking opening.

Even in the case of preparing for diversifying the gap between the housing body and the printed circuit board, it is unnecessary to prepare various housings respectively equipped with stand-off projection portions being different in height from one another. Accordingly, the present invention can easily cope with change of the gap between the housing body of the board connector and the printed circuit board.

With the above configuration (2), when the board connector is attached to the printed circuit board, the soldering terminal of the board connector is inserted into the through-hole of the printed circuit board upwardly from below. Thus, when the soldering terminal of the board connector and the through-hole of the printed circuit board are soldered to each other by the reflow method, a part of the solder paste charged into the through-hole is upwardly pushed out by the soldering terminal inserted through the through-hole. However, it does not occur that the solder paste is dropped downwardly without adhering to the soldering terminal.

Further, when the soldering is performed according to the flow method, it is advisable to turn, after the board connector is attached to the printed circuit board, the printed circuit board and the board connector upside down so that the printed circuit board hangs down from the board connector.

Accordingly, with the above configuration (2), the soldering terminal and the through-hole can be satisfactorily conductively connected to each other by performing either the flow soldering method or the reflow soldering method.

With the above configuration (3), the stand-off value that indicates the size of the gap between the printed circuit board and the housing body is changed to a desired value by changing the diameter of the connector locking opening. Thus, when the gap between the housing body of the board connector and the printed circuit board is changed, the modification and the like of the board connector are not needed at all. Consequently, the present invention can easily cope with change in the gap between the housing body of the board connector and the printed circuit board.

### Advantageous Effects of Invention

According to the connection structure and the connection method of the board connector of the present invention, the contact surface of the locking protrusion portion of the board connector, which is contacted with the board-backsurface-side edge of the connector locking opening of the printed circuit board, is formed to be an inclined surface on which the printed circuit board moves away from the board connector in a case where the diameter of the connector locking opening increases. Thus, change in the gap between the printed circuit board and the housing body of the board connector can easily be coped with only by increasing or decreasing the diameter of the connector locking opening.

Even in the case of preparing for diversifying the gap between the housing body and the printed circuit board, it is unnecessary to prepare various housings respectively equipped with stand-off projection portions that differ in height from one another. Consequently, the present invention can easily cope with change of the gap between the housing body and the printed circuit board.

In the foregoing description, the present invention has briefly been described. However, details of the present invention will be further clarified by reading through the following description of a mode for carrying out the present invention (hereinafter referred to as an "embodiment") with reference to the accompanying drawings.

### Brief Description of Drawings

FIG. 1 is a perspective view illustrating a board connector according to an embodiment of the connection structure of the board connector according to the present invention.
FIG. 2 is an enlarged front view illustrating an elastic locking piece and a stand-off protrusion portion illustrated in FIG. 1.
FIG. 3(a) is an explanatory view illustrating a state in which a thin printed circuit board engages with the elastic locking piece and the stand-off projection portion illustrated in FIG. 2, and FIG. 3(b) is an explanatory view illustrating a state in which a thick printed circuit board engages with the elastic locking piece and the stand-off projection portion illustrated in FIG. 2.
FIG. 4(a) is a side view illustrating a state in which the printed circuit board is hung from the board connector illustrated in FIG. 1, and FIG. 4(b) is a side view illustrating a state in which the board connector illustrated in FIG. 1 is hung from the printed circuit board.
FIG. 5(a) is an explanatory view illustrating a state in which a soldering terminal of the board connector is inserted into a through-hole of the printed circuit board from above, and FIG. 5(b) is an explanatory view illustrating a state in which the soldering terminal of the board connector is inserted into the through-hole of the printed circuit board from below.
FIG. 6 is an explanatory view illustrating a state in which the gap between the printed circuit board and the housing body of the board connector is increased because the connector locking opening of the printed circuit board is equipped by being increased in diameter from a standard size.
FIG. 7 is an explanatory view illustrating the relationship of the gap between the printed circuit board and the housing body of the board connector with the protruding length of the soldering terminal in a case where an increase in the diameter of the connector locking opening of the printed circuit board is relatively small.
FIG. 8 is an explanatory view illustrating the relationship of the gap between the printed circuit board and the housing body of the board connector with the protruding length of the soldering terminal in a case where an increase in the diameter of the connector locking opening of the printed circuit board is relatively large.
FIG. 9 is a cross-sectional view illustrating a conventional board connector.

### Description of Embodiments

Hereinafter, a preferred embodiment of a connection structure and a connection method of a board connector according to the present invention are described in detail with reference to the drawings.

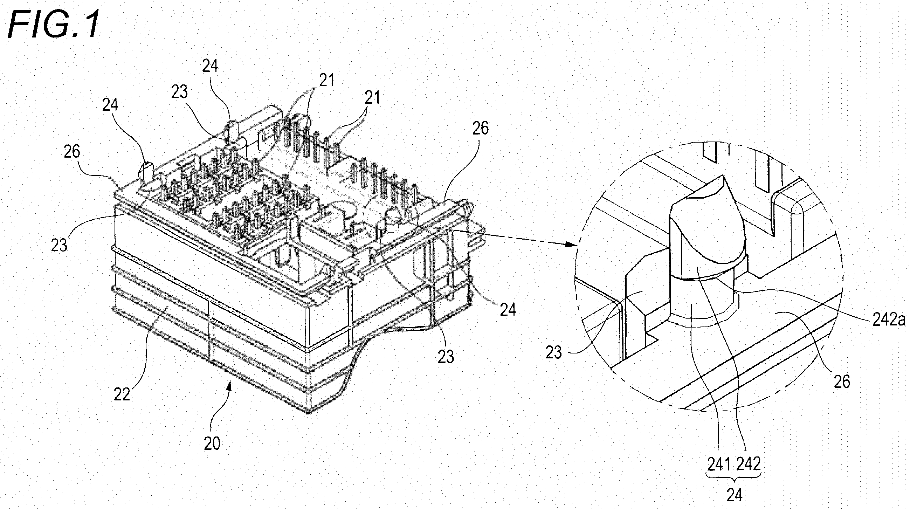

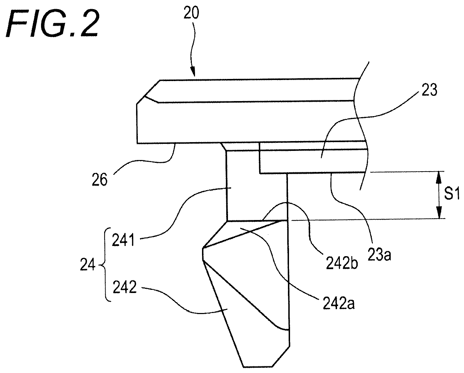

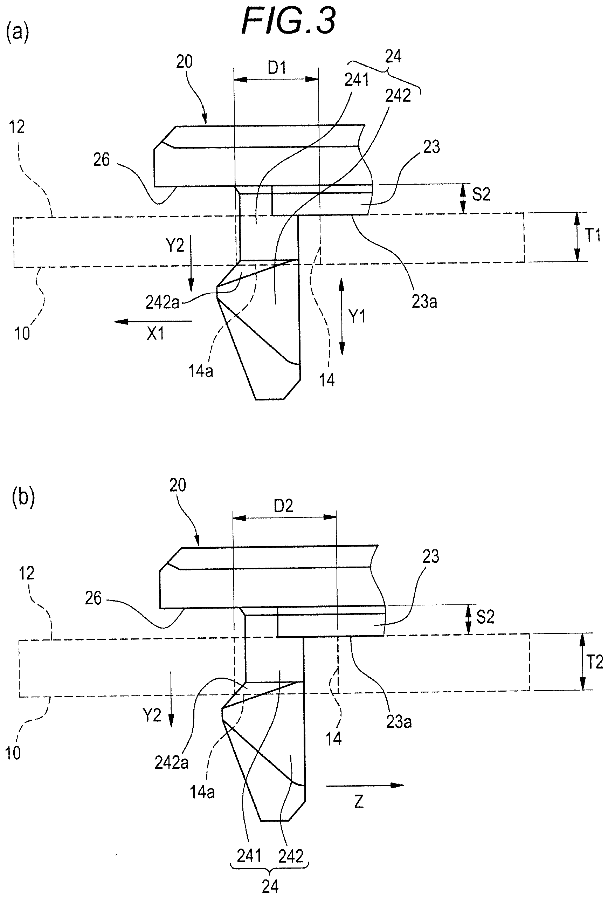

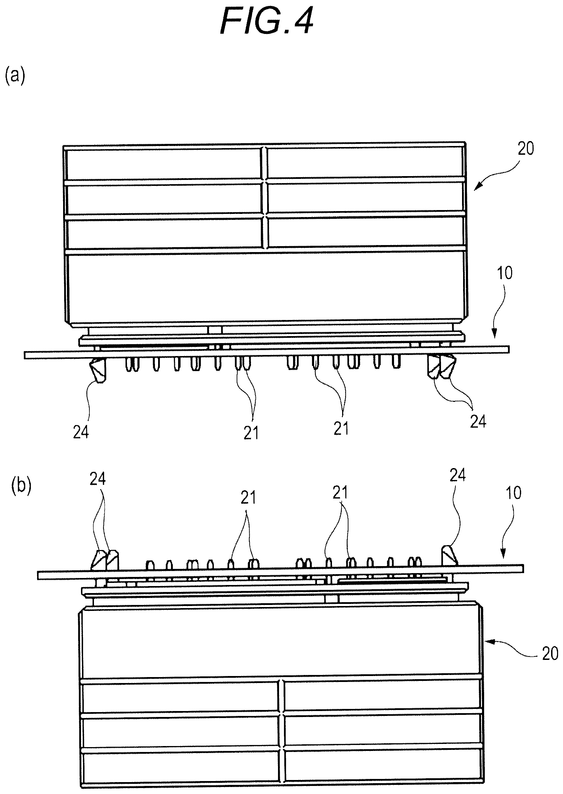

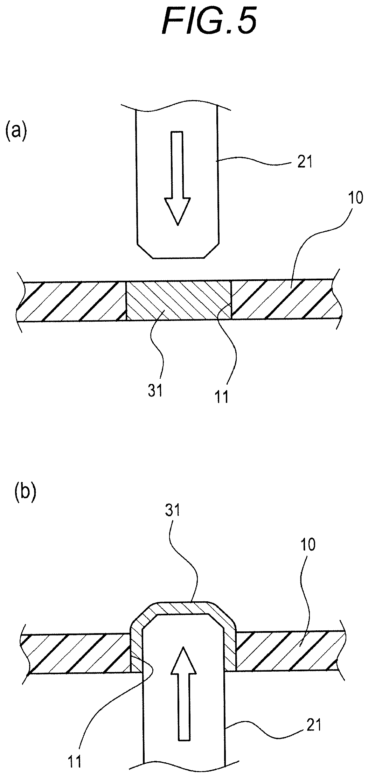

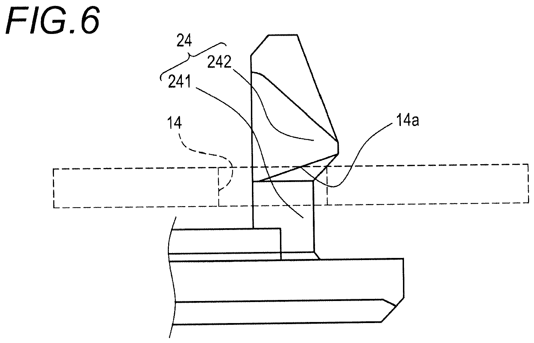

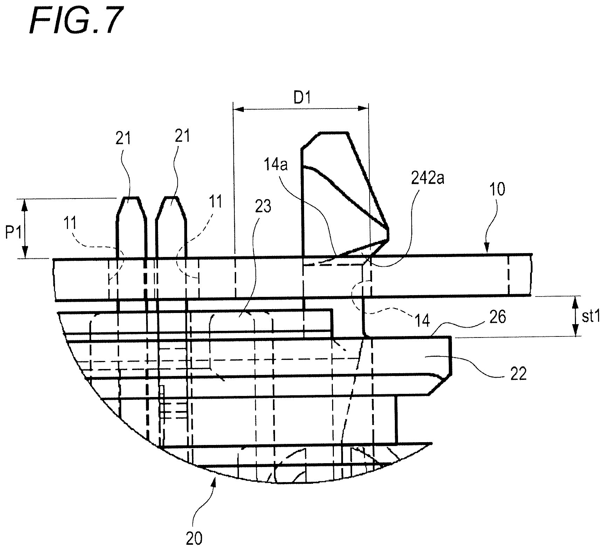

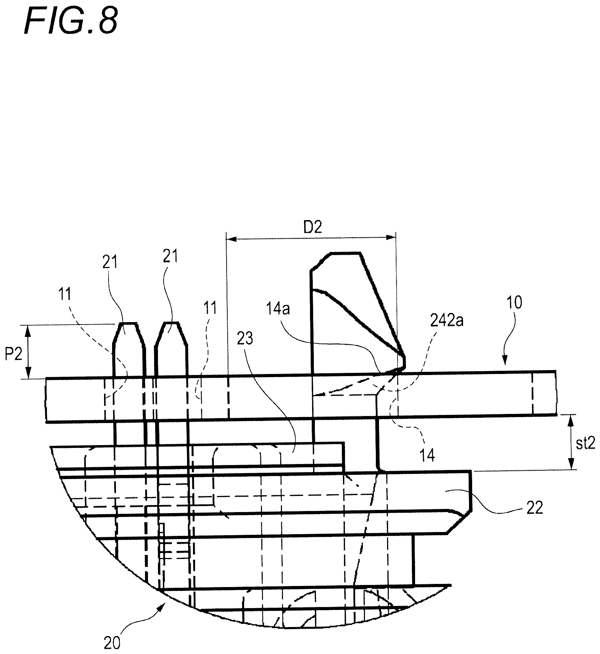

FIGS. 1 to 8 illustrate an embodiment of each of the connection structure and the connection method of the board connector according to the present invention. FIG. 1 is a perspective view illustrating a board connector according to the embodiment of the present invention. FIG. 2 is an enlarged front view illustrating an elastic locking piece and a stand-off protrusion portion illustrated in FIG. 1. FIG. 3(a) is an explanatory view illustrating a state in which a thin printed circuit board engages with the elastic locking piece and the stand-off projection portion illustrated in FIG. 2. FIG. 3(b) is an explanatory view illustrating a state in which a thick printed circuit board engages with the elastic locking piece and the stand-off projection portion illustrated in FIG. 2. FIG. 4(a) is a side view illustrating a state in which the printed circuit board is hung from the board connector illustrated in FIG. 1. FIG. 4(b) is a side view illustrating a state in which the board connector illustrated in FIG. 1 is hung from the printed circuit board. FIG. 5(a) is an explanatory view illustrating a state in which a soldering terminal of the board connector is inserted into a through-hole of the printed circuit board from above. FIG. 5(b) is an explanatory view illustrating a state in which the soldering terminal of the board connector is inserted into the through-hole of the printed circuit board from below. FIG. 6 is an explanatory view illustrating a state in which the gap between the printed circuit board and the housing body of the board connector is increased because a connector locking opening of the printed circuit board is equipped by being increased in diameter from a standard value. FIG. 7 is an explanatory view illustrating the relationship of the gap between the printed circuit board and the housing body of the board connector with the protruding length of the soldering terminal in a case where an increase in the diameter of the connector locking opening of the printed circuit board is relatively small. FIG. 8 is an explanatory view illustrating the relationship of the gap between the printed circuit board and the housing body of the board connector with the protruding length of the soldering terminal in a case where an increase in the diameter of the connector locking opening of the printed circuit board is relatively large.

In this embodiment, as illustrated in FIG. 1, a board connector 20 connected to a printed circuit board 10 (see FIG. 4) includes a plurality of soldering terminals 21, a single housing body 22, a set of stand-off projection portions 23, and a set of elastic locking pieces (sometimes referred to also as snap-fits) 24.

The soldering terminals 21 are rod-like terminals that are inserted through the through-holes 11 in the printed circuit board 10 illustrated in FIG. 7, respectively, and soldered to a contact pattern associated with the through-holes 11.

The housing body 22 is a housing formed into a predetermined shape by resin injection molding, and holds the soldering terminals 21 at a predetermined arrangement pitch. Further, the housing body 22 holds the plural soldering terminals 21 in a state in which the soldering terminals 21 are arrayed to protrude a predetermined protruding length from a bottom surface 26 facing the printed circuit board 10.

A set of stand-off projection portions 23 is configured by three stand-off projection portions 23, as illustrated in FIG. 1.

Each stand-off projection portion 23 is a member that ensures a gap between the housing body 22 and a surface of the printed circuit board 10 by reason of improvement of the flow of molten solder, prevention of the thermal fatigue of the board after mounting, and the like. As illustrated in FIGS. 2, 3(a), and 3(b), each stand-off projection portion 23 is formed integrally with the housing body 22 to protrude from the bottom surface 26 to the side of the printed circuit board 10. Moreover, in the case of this embodiment, each stand-off projection portion 23 is formed integrally with the root of the elastic locking piece 24.

When the housing body 22 is attached to the printed circuit board 10 having a thickness T1 or T2, as illustrated in FIG. 3(a) or 3(b), each stand-off projection portion 23 is such that a tip end 23a abuts on a surface 12 of the printed circuit board 10. Consequently, a gap S2 is ensured between the printed circuit board 10 and the housing body 22.

As illustrated in FIG. 1, a set of elastic locking pieces 24 is configured by three elastic locking pieces 24. Each elastic locking piece 24 adjoins and is formed integrally with the above stand-off projection portion 23. As illustrated in FIGS. 1 and 2, each elastic locking portion 24 includes an elastic piece 241 extending in a thickness direction (i.e., a direction indicated by arrow Y1 in FIG. 3(a)) of the printed circuit board 10 from the housing body 22, and a locking protrusion portion 242 provided at a tip end of the elastic piece 241 so as to protrude therefrom. The locking protrusion portion 242 is provided to protrude in a direction (i.e., a direction indicated by arrow X1 in FIG. 3(a)) orthogonal to the thickness direction of the printed circuit board 10.

As illustrated in FIGS. 3(a) and 3(b), the above elastic locking piece 24 is such that the elastic piece 241 is inserted through the connector locking opening 14 formed to penetrate through the printed circuit board 10. Further, the locking protrusion portion 242 inserted through the connector locking opening 14 and protruded from the backsurface side of the printed circuit board 10 engages with a board-backsurface-side edge 14a of the connector locking opening 14. Thus, the elastic locking piece 24 restricts the board connector 20 from falling off the printed circuit board 10 when soldering is performed according to the reflow method.

The connection structure of the board connector according to this embodiment is a structure that causes the elastic locking piece 24 to engage with the board-backsurface-side edge 14a of the connector locking opening 14 through which the elastic piece 241 can be inserted, to thereby put the board connector 20 into a state in which the board connector 20 is connected to the printed circuit board 10.

Incidentally, in the case of this embodiment, the locking protrusion portion 242 has a contact surface 242a to be contacted with the board-backsurface-side edge 14a of the connector locking opening 14. Further, this contact surface 242a is formed to be an inclined surface on which the printed circuit board 10 moves in a direction (i.e., a direction indicated by arrow Y2 in FIGS. 3(a) and 3(b)) in which the printed circuit board 10 moves away from the board connector 20 if the diameter D1 or D2 of the connector locking opening 14 illustrated in FIG. 3(a) or 3(b) increases. The diameter D2 of the connector locking opening 14 illustrated in FIG. 3(b) is illustrated as the diameter in the case of being increased from the diameter of the connector locking opening 14, which is illustrated in FIG. 3(a).

Here, for description of operations performed by the elastic locking piece 24 and the connector locking opening 14, each of FIGS. 3(a) and 3(b) illustrates, as the printed circuit board 10, a board configured such that an associated one of the thicknesses T1 and T2 of the printed circuit board 10 is set to be larger than a separation distance S1 between a base end 242b of the contact surface 242a and a tip end 23a of the stand-off projection portion 23 illustrated in FIG. 2.

However, in the case of this embodiment, a board configured in the following manner is used as the printed circuit board 10. That is, the board is configured such that the thicknesses T1 is set to be less than the separation distance S1 between the base end 242b of the contact surface 242a and the tip end 23a of the stand-off projection portion 23 illustrated in FIG. 2. Incidentally, the base end of the contact surface 242a is an end portion closest to the tip end 23a of the stand-off projection portion 23 on the contact surface 242a.

Further, in the case of this embodiment, the printed circuit board 10 is configured by setting the diameter D1 of the connector locking opening 14 such that a protruding length P1 of the soldering terminal 21 illustrated in FIG. 7 from the through-hole 11 is matched with a target value by the contact between the board-backsurface-side edge 14a of the connector locking opening 14 and the contact surface 242a.

Furthermore, in the case of this embodiment, the connection between the printed circuit board 10 and the board connector 20 is performed in a direction in which the board connector 20 is hung from the printed circuit board 10, as illustrated in FIG. 4(b), instead of a direction in which the printed circuit board 10 is hung from the board connector 20, as illustrated in FIG. 4(a).

And, according to the connection method of the board connector of this embodiment, each soldering terminal 21 is preliminarily soldered to the associated through-hole 11 by what is called a reflow method in which each through-hole 11 is filled with solder paste before each soldering terminal 21 is inserted through the associated through-hole 11. Thus, the board connector 20 and the printed circuit board 10 are put into a state in which the board connector 20 and the printed circuit board 10 are electrically connected to each other.

Further, the connection method of the board connector according to this embodiment changes the size of the gap (i.e., the stand-off value) between the printed circuit board 10 and the housing body 22 by changing the diameter of the connector locking opening 14 to a desired value.

For example, it is assumed that a stand-off value st1 and a protruding length P1 of each soldering terminal 21 from the printed circuit board 10 are initially obtained by setting the diameter of the connector locking opening 14 at D1, as illustrated in FIG. 7.

A case of changing connector connection conditions from those illustrated in FIG. 7 to those illustrated in FIG. 8 is described hereinafter. The connector connection conditions illustrated in FIG. 8 are such that the stand-off value is increased to st2. Further as the stand-off value is increased to st2, the protruding length of each soldering terminal 21 from the printed circuit board 10 is changed to a reduced value P2. Thus, the diameter of the connector locking opening 14 is changed to D2 so that the stand-off value is st2, and that the protruding length of the soldering terminal 21 is P2.

In the connection structure of the board connector according to the one embodiment described above, the contact surface 242a of the locking protrusion portion 242 of the board connector 20, which is contacted with the board-backsurface-side edge 14a of the connector locking opening 14 of the printed circuit board 10, is formed to be an inclined surface on which the printed circuit board 10 moves in a direction in which the printed circuit board 10 moves away from the board connector 20 if the diameter of the connector locking opening 14 is increased, as illustrated in FIGS. 7 and 8. Therefore, change in the gap between the housing body 22 of the board connector 20 and the printed circuit board 10 can easily be coped with only by increasing or decreasing the diameter of the connector locking opening 14.

Even in the case of preparing for the diversification of the gap between the housing body 22 and the printed circuit board 10, it is unnecessary to prepare various housing bodies respectively equipped with stand-off projection portions 23 differing in height from one another. Accordingly, this embodiment can easily cope with change in the gap between the housing body 22 of the board connector 20 and the printed circuit board 10.

Incidentally, as a result of forming the contact surface 242a to be an inclined surface, even if the thickness of the printed circuit board 10 is a thickness T2 being larger than a thickness T1 which is a standard size, under the influence of a dimensional tolerance and a working error, the locking of the printed circuit board 10 by the elastic locking pieces 24 is enabled by changing the diameter of the connector locking opening 14 to the diameter D2 obtained by being increased from the standard diameter D1, as illustrated in FIG. 3(b). In this case, if the diameter of the connector locking opening 13 is set at a size at which each elastic locking piece 24 flexurally deforms in a direction indicated by arrow Z in FIG. 3(b), an increase in the thickness of the printed circuit board 10 can be absorbed. In addition, backlash of each of the printed circuit board 10 and the board connector 20 can be prevented.

Dimension errors are easily absorbed by forming the contact surface 242a to be an inclined surface. Consequently, workability at the time of attaching the board connector 20 to the printed circuit board 10 can be improved.

Further, in the case of the connection method of the board connector, in which the soldering terminals of the board connector are inserted into the through-holes of the printed circuit board from above, if the soldering terminals are soldered according to the reflow method, when the soldering terminal 21 is inserted through the through-hole 11 of the printed circuit board 10, as illustrated in FIG. 5(a), solder paste 31 charged into the through-hole 11 is downwardly pushed out of the through-hole 11 by the soldering terminal 21. Consequently, sometimes, troubles occur, in which the solder paste 31 is dropped down from the through-hole 11 without adhering to the soldering terminal 21.

However, in the case of the above connection method of the board connector according to the one embodiment described above, as illustrated in FIG. 5(b), when the board connector 20 is attached to the printed circuit board 10, the soldering terminal 21 of the board connector 20 is inserted into the through-hole 11 of the printed circuit board 10 upwardly from below. Thus, when the soldering terminal 21 of the board connector 20, and the through-hole 11 of the printed circuit board 10 are soldered to each other according to the reflow method, a part of the solder paste 31 charged into the through-hole 11 is upwardly pushed out by the soldering terminal 21 inserted through the through-hole 11, as illustrated in FIG. 5(b). However, it doesn't occur that the solder paste 31 is dropped downwardly without adhering to the soldering terminal 21.

Incidentally, in the case of the connection method of connecting the printed circuit board 10 and the board connector 20 according to the one embodiment, when the soldering is performed according to the flow method, it is advisable to turn, after the board connector 20 is attached to the printed circuit board 10, the printed circuit board 10 and the board connector 20 upside down so that the printed circuit board 10 hangs down from the board connector 20.

Accordingly, the connection method of the board connector according to the one embodiment described above can satisfactorily conductively connect between the soldering terminal 21 and the through-hole 11 to each other by performing either the flow soldering method or the reflow soldering method.

Further, the connection method of the board connector according to the one embodiment described above changes the size of the gap (i.e., the stand-off value) between printed circuit board 10 and the housing body 22 to a desired value by changing the diameter of the connector locking opening 14. Therefore, when the gap between the housing body 22 of the board connector 20 and the printed circuit board 10 is changed, the modification and the like of the board connector 20 are not needed at all. Thus, the connection method of the board connector according to the one embodiment can easily cope with change in the gap between the housing body 22 of the board connector 20 and the printed circuit board 10.

Here, the above features of the connection structure and the connection method of the board connector according to the present invention are briefly summarized and listed in the following items [1] to [3].
[1] A connection structure of a board connector (20) to a printed circuit board (10), in which
   the board connector (20) includes
   a soldering terminal (21) configured to be soldered to a through-hole (11) of the printed circuit board (10),
   a housing body (22) configured to hold the soldering terminal (21) so that the soldering terminal (21) protrudes from the printed circuit board (10) a predetermined length,
   a stand-off projection portion (23) provided on the housing body (22) to protrude from the housing body (22), and configured to abut on the printed circuit board (10) when the housing body (22) is attached to the printed circuit board (10), to thereby ensure a gap between the printed circuit board (10) and the housing body (22), and
   an elastic locking piece (24) including a locking protrusion portion (242) that protrudes in a direction orthogonal to a direction of thickness of the printed circuit board (10) and is provided at a tip end of an elastic piece (241) extending in the direction of thickness of the printed circuit board (10) from the housing body (22), wherein the locking protrusion portion (242) engages with a board-backsurface-side edge (14a) of a connector locking opening (14) formed to penetrate through the printed circuit board (10) and to allow the elastic piece (241) to be inserted through the connector locking opening (14), thereby restricting the board connector (20) from falling off the printed circuit board (10), wherein
   the board connector (20) is put into a state in which the board connector (20) is connected to the printed circuit board (10), by engaging the elastic locking piece (24) with the board-backsurface-side edge (14a) of the connector locking opening (14),
   a contact surface (242a) of the locking protrusion portion (242) configured to be contacted with the board-backsurface-side edge (14a) of the connector locking opening (14) is formed to be an inclined surface on which the printed circuit board (10) moves in a direction in which the printed circuit board (10) moves away from the board connector (20) in a case where a diameter of the connector locking opening (14) is increased, and
   the printed circuit board (10), whose thickness is set to be smaller than a separation distance between a base end of the contact surface (242a) and a tip end of the stand-off projection portion (23), is used, and also the diameter of the connector locking opening (14) is set so that a protruding length of the soldering terminal (21) from the through-hole (11) is matched with a target value by contact between the board-backsurface-side edge (14a) of the connector locking opening (14) and the contact surface (242a).
[2] A connection method of a board connector (20) to a printed circuit board (10), in which in a connection structure of the board connector (20),
   the board connector (20) includes
   a soldering terminal (21) configured to be soldered to a through-hole (11) of the printed circuit board (10),
   a housing body (22) configured to hold the soldering terminal (21) so that the soldering terminal (21) protrudes from the printed circuit board (10) a predetermined length,
   a stand-off projection portion (23) provided on the housing body (22) to protrude from the housing body (22), and configured to abut on the printed circuit board (10) when the housing body (22) is attached to the printed circuit board (10), to thereby ensure a gap between the printed circuit board (10) and the housing body (22), and
   an elastic locking piece (24) including a locking protrusion portion (242) that protrudes in a direction orthogonal to a direction of thickness of the printed circuit board (10) and is provided at a tip end of an elastic piece (241) extending in the direction of thickness of the printed circuit board (10) from the housing body (22), wherein the locking protrusion portion (242) engages with a board-backsurface-side edge (14a) of a connector locking opening (14) formed to penetrate through the printed circuit board (10) and to allow the elastic piece (241) to be inserted through the connector locking opening (14), thereby restricting the board connector (20) from falling off the printed circuit board (10), wherein
   the board connector (20) is put into a state in which the board connector (20) is connected to the printed circuit board (10), by engaging the elastic locking piece (24) with the board-backsurface-side edge (14a) of the connector locking opening (14),
   a contact surface (242a) of the locking protrusion portion (242) configured to be contacted with the board-backsurface-side edge (14a) of the connector locking opening (14) is formed to be an inclined surface on which the printed circuit board (10) moves in a direction in which the printed circuit board (10) moves away from the board connector (20) in a case where a diameter of the connector locking opening (14) is increased,
   the printed circuit board (10), whose thickness is set to be smaller than a separation distance between a base end of the contact surface (242a) and a tip end of the stand-off projection portion (23), is used, and also the diameter of the connector locking opening (14) is set so that a protruding length of the soldering terminal (21) from the through-hole (11) is matched with a target value by contact between the board-backsurface-side edge (14a) of the connector locking opening (14) and the contact surface (242a), wherein
   connection between the printed circuit board (10) and the board connector (20) is performed in a direction in which the board connector (20) hangs down from the printed circuit board (10), and
   such that the board connector (20) and the printed circuit board (10) are put into a connected state by soldering the soldering terminal (21) to the through-hole (11) according to a reflow method in which the through-hole (11) is filled with solder paste before the soldering terminal (21) is inserted through the through-hole (11).
[3] The connection method of the board connector (20) according to the above item [2], wherein a stand-off value that indicates a size of the gap between the printed circuit board (10) and the housing body (22) is changed to a desired value by changing the diameter of the connector locking opening (14).

Incidentally, the present invention is not limited to the above embodiment. Appropriate modification, improvement, and the like can be made. Besides, the materials, shapes, dimensions, numbers, arrangement locations, and the like of components of the above embodiment are optional and not limited to specific ones, as long as the present invention can be achieved.

For example, the number of the stand-off projection portions and the elastic locking pieces equipped in the board connector is not limited to the numerical quantity described in the above embodiment and can be increased or decreased according to the size or the like of the printed circuit board and the board connector.

The present application is based on Japanese Patent Application No. 2012-185742 filed on August 24, 2012.

### Industrial Applicability

According to the connection structure and the connection method of the board connector of the present invention, the contact surface of the locking protrusion portion of the board connector, which is contacted with the board-backsurface-side edge of the connector locking opening of the printed circuit board, is formed to be an inclined surface on which a printed circuit board moves away from a board connector if the diameter of a connector locking opening increases. Thus, change in the gap between the printed circuit board and the housing body of the board connector can easily be coped with only by increasing or decreasing the diameter of the connector locking opening.

Even in the case of preparing for diversifying the gap between the housing body and the printed circuit board, it is unnecessary to prepare various housings respectively equipped with stand-off projection portions that differ in height from one another. Consequently, the board connector can easily cope with change of the gap between the housing body and the printed circuit board.

The present invention achieving such advantages is useful in the field of the connection structure and the connection method of a board connector.

### Reference Signs List

- 10:: printed circuit board

- 11:: through-hole
- 14:: connector locking opening
- 14a:: board-backsurface-side edge
- 20:: board connector
- 21:: soldering terminal
- 22:: housing body
- 23:: stand-off projection portion
- 24:: elastic locking piece
- 241:: elastic piece
- 242:: locking protrusion portion
- 242a:: contact surface
- 242b:: base end portion
- st1:: gap

## Claims

1. A connection structure of a board connector (20) to a printed circuit board (10), the board connector (20) comprising:
a soldering terminal (21) configured to be soldered to a through-hole (11) of the printed circuit board (10);
a housing body (22) configured to hold the soldering terminal (21) so that the soldering terminal (21) protrudes from the printed circuit board (10) a predetermined length;
a stand-off projection portion (23) provided on the housing body (22) to protrude from the housing body (22), and configured to abut on the printed circuit board (10) when the housing body (22) is attached to the printed circuit board (10), to thereby ensure a gap between the printed circuit board (10) and the housing body (22); and
an elastic locking piece (24) including a locking protrusion portion (242) that protrudes in a direction orthogonal to a direction of thickness of the printed circuit board (10) and is provided at a tip end of an elastic piece (241) extending in the direction of thickness of the printed circuit board (10) from the housing body (22),
wherein the locking protrusion portion (242) engages with a board-backsurface-side edge (14a) of a connector locking opening (14) formed to penetrate through the printed circuit board (10) and to allow the elastic piece (241) to be inserted through the connector locking opening (14), thereby restricting the board connector (20) from falling off the printed circuit board (10), wherein
the board connector (20) is put into a state in which the board connector (20) is connected to the printed circuit board (10) by engaging the elastic locking piece (24) with the board-backsurface-side edge (14a) of the connector locking opening (14), **characterised in that** a contact surface (242a) of the locking protrusion portion (242) configured to be contacted with the board-backsurface-side edge (14a) of the connector locking opening (14) is formed to be an inclined surface on which the printed circuit board (10) moves in a direction in which the printed circuit board (10) moves away from the board connector (20) in a case where a diameter (D1) of the connector locking opening (14) is increased, and
the printed circuit board (10), whose thickness (T1) is set to be smaller than a separation distance (S1) between a base end (242b) of the contact surface (242a) and a tip end (23a) of the stand-off projection portion (23), is used, and also the diameter (D1) of the connector locking opening (14) is set so that a protruding length (P1) of the soldering terminal (21) from the through-hole (11) is matched with a target value by contact between the board-backsurface-side edge (14a) of the connector locking opening (14) and the contact surface (242a).

2. A connection method of a board connector (20) to a printed circuit board (10), wherein,
in a connection structure of the board connector (20), the board connector (20) comprises:
a soldering terminal (21) configured to be soldered to a through-hole (11) of the printed circuit board (10);
a housing body (22) configured to hold the soldering terminal (21) so that the soldering terminal (21) protrudes from the printed circuit board (10) a predetermined length;
a stand-off projection portion (23) provided on the housing body (22) to protrude from the housing body (22), and configured to abut on the printed circuit board (10) when the housing body (22) is attached to the printed circuit board (10), to thereby ensure a gap between the printed circuit board (10) and the housing body (22); and
an elastic locking piece (24) including a locking protrusion portion (242) that protrudes in a direction orthogonal to a direction of thickness of the printed circuit board (10) and is provided at a tip end of an elastic piece (241) extending in the direction of thickness of the printed circuit board (10) from the housing body (22),
wherein the locking protrusion portion (242) engages with a board-backsurface-side edge (14a) of a connector locking opening (14) formed to penetrate through the printed circuit board (10) and to allow the elastic piece (241) to be inserted through the connector locking opening (14), thereby restricting the board connector (20) from falling off the printed circuit board (10), wherein
the board connector (20) is put into a state in which the board connector (20) is connected to the printed circuit board (10) by engaging the elastic locking piece (24) with the board-backsurface-side edge (14a) of the connector locking opening (14), **characterised in that** a contact surface (242a) of the locking protrusion portion (242) configured to be contacted with the board-backsurface-side edge (14a) of the connector locking opening (14) is formed to be an inclined surface on which the printed circuit board (10) moves in a direction in which the printed circuit board (10) moves away from the board connector (20) in a case where a diameter (D1) of the connector locking opening (14) is increased, and
the printed circuit board (10), whose thickness (T1) is set to be smaller than a separation distance (S1) between a base end (242b) of the contact surface (242a) and a tip end (23a) of the stand-off projection portion (23), is used, and also the diameter (D1) of the connector locking opening (14) is set so that a protruding length (P1) of the soldering terminal (21) from the through-hole (11) is matched with a target value by contact between the board-backsurface-side edge (14a) of the connector locking opening (14) and the contact surface (242a), wherein
connection between the printed circuit board (10) and the board connector (20) is performed in a direction in which the board connector (20) hangs down from the printed circuit board (10), and
the board connector (20) and the printed circuit board (10) are put into a connected state by soldering the soldering terminal (21) to the through-hole (11) according to a reflow method in which the through-hole (11) is filled with solder paste before the soldering terminal (21) is inserted through the through-hole (11).

3. The connection method of the board connector (20) according to claim 2, wherein a stand-off value that indicates a size of the gap between the printed circuit board (10) and the housing body (22) is changed to a desired value by changing the diameter of the connector locking opening (14).

## Patentansprüche

1. Verbindungsstruktur eines Leiterplattenverbinders (20) zu einer gedruckten Leiterplatte (10), wobei der Leiterplattenverbinder (20) aufweist:
einen Lötanschluss (21), der ausgebildet ist, mit einer Durchgangsbohrung (11) der gedruckten Leiterplatte (10) verlötet zu werden;
einen Gehäusekörper (22), der ausgebildet ist, den Lötanschluss (21) derart zu halten, dass der Lötanschluss (21) aus der gedruckten Leiterplatte (10) mit einer vorbestimmten Länge hervorsteht;
einen Abstandsvorsprungsbereich (23), der an dem Gehäusekörper (22) so vorgesehen ist, dass er aus dem Gehäusekörper (22) hervorsteht, und der ausgebildet ist, an der gedruckten Leiterplatte (10) anzuliegen, wenn der Gehäusekörper (22) an der gedruckten Leiterplatte (10) angebracht ist, um dadurch einen Spalt zwischen der gedruckten Leiterplatte (10) und dem Gehäusekörper (22) zu gewährleisten; und
ein elastisches Verriegelungsstück (24) mit einem Verriegelungsvorsprungsbereich (242), der in einer Richtung senkrecht zu einer Richtung der Dicke der gedruckten Leiterplatte (10) hervorsteht und an einem vorderen Ende eines elastischen Stücks (241) vorgesehen ist, das sich in der Richtung der Dicke der gedruckten Leiterplatte (10) ausgehend von dem Gehäusekörper (22) erstreckt, wobei der Verriegelungsvorsprungsbereich (242) mit einer leiterplattenrückseitigen Kante (14a) einer Verbinderverriegelungsöffnung (14) im Eingriff steht, die so ausgebildet ist, dass sie die gedruckte Leiterplatte (10) durchdringt und ermöglicht, dass das elastische Stück (241) durch die Verbinderverriegelungsöffnung (14) eingeführt wird, wodurch verhindert wird, dass der Leiterplattenverbinder (20) von der gedruckten Leiterplatte (10) abfällt, wobei
der Leiterplattenverbinder (20) in einen Zustand versetzt wird, in welchem der Leiterplattenverbinder (20) mit der gedruckten Leiterplatte (10) verbunden wird, indem das elastische Verriegelungsstück (24) mit der leiterplattenrückseitigen Kante (14a) der Verbinderverriegelungsöffnung (14) in Eingriff gebracht wird,
**dadurch gekennzeichnet, dass**
eine Kontaktfläche (242a) des Verriegelungvorsprungsbereichs (242), die zum In-Kontakttreten mit der leiterplattenrückseitigen Kante (14a) der Verbinderverriegelungsöffnung (14) ausgebildet ist, an einer geneigten Oberfläche ausgebildet ist, auf der die gedruckte Leiterplatte (10) sich in einer Richtung bewegt, in der sich die gedruckte Leiterplatte (10) von dem Leiterplattenverbinder (20) wegbewegt, wenn ein Durchmesser (D1) der Verbinderverriegelungsöffnung (14) vergrößert wird, und
diejenige gedruckte Leiterplatte (10) verwendet ist, deren Dicke (T1) kleiner als ein Trennungsabstand (S1) zwischen einem Basisende (242b) der Kontaktfläche (242a) und einem vorderen Ende (23a) des Abstandsvorsprungsbereichs (23) festgelegt ist, und auch der Durchmesser (D1) der Verbinderverriegelungsöffnung (14) so festgelegt ist, dass eine Überstandslänge (P1) des Lötanschlusses (21) ausgehend von der Durchgangsbohrung (11) einem Sollwert durch Kontakt zwischen der leiterplattenrückseitigen Kante (14a) der Verbinderverriegelungsöffnung (14) und der Kontaktfläche (242a) angepasst ist.

2. Verfahren zum Verbinden eines Leiterplattenverbinders (20) mit einer gedruckten Leiterplatte (10), wobei
in einer Verbindungsstruktur des Leiterplattenverbinders (20) der Leiterplattenverbinder (20) aufweist:
einen Lötanschluss (21), der ausgebildet ist, mit einer Durchgangsbohrung (11) der gedruckten Leiterplatte (10) verlötet zu werden;
einen Gehäusekörper (22), der ausgebildet ist, den Lötanschluss (21) derart zu halten, dass der Lötanschluss (21) aus der gedruckten Leiterplatte (10) mit einer vorbestimmten Länge hervorsteht;
einen Abstandsvorsprungsbereich (23), der an dem Gehäusekörper (22) so vorgesehen ist, dass er aus dem Gehäusekörper (22) hervorsteht, und der ausgebildet ist, an der gedruckten Leiterplatte (10) anzuliegen, wenn der Gehäusekörper (22) an der gedruckten Leiterplatte (10) angebracht ist, um dadurch einen Spalt zwischen der gedruckten Leiterplatte (10) und dem Gehäusekörper (22) zu gewährleisten; und
ein elastisches Verriegelungsstück (24) mit einem Verriegelungsvorsprungsbereich (242), der in einer Richtung senkrecht zu einer Richtung der Dicke der gedruckten Leiterplatte (10) hervorsteht und an einem vorderen Ende eines elastischen Stücks (241) vorgesehen ist, das sich in der Richtung der Dicke der gedruckten Leiterplatte (10) ausgehend von dem Gehäusekörper (22) erstreckt, wobei der Verriegelungsvorsprungsbereich (242) mit einer leiterplattenrückseitigen Kante (14a) einer Verbinderverriegelungsöffnung (14) im Eingriff steht, die so ausgebildet ist, dass sie die gedruckte Leiterplatte (10) durchdringt und ermöglicht, dass das elastische Stück (241) durch die Verbinderverriegelungsöffnung (14) eingeführt wird, wodurch verhindert wird, dass der Leiterplattenverbinder (20) von der gedruckten Leiterplatte (10) abfällt, wobei
der Leiterplattenverbinder (20) in einen Zustand versetzt wird, in welchem der Leiterplattenverbinder (20) mit der gedruckten Leiterplatte (10) verbunden wird, indem das elastische Verriegelungsstück (24) mit der leiterplattenrückseitigen Kante (14a) der Verbinderverriegelungsöffnung (14) in Eingriff gebracht wird,
**dadurch gekennzeichnet, dass**
eine Kontaktfläche (242a) des Verriegelungvorsprungsbereichs (242), die zum In-Kontakttreten mit der leiterplattenrückseitigen Kante (14a) der Verbinderverriegelungsöffnung (14) ausgebildet ist, an einer geneigten Oberfläche ausgebildet ist, auf der die gedruckte Leiterplatte (10) sich in einer Richtung bewegt, in der sich die gedruckte Leiterplatte (10) von dem Leiterplattenverbinder (20) wegbewegt, wenn ein Durchmesser (D1) der Verbinderverriegelungsöffnung (14) vergrößert wird, und
diejenige gedruckte Leiterplatte (10) verwendet wird, deren Dicke (T1) kleiner als ein Trennungsabstand (S1) zwischen einem Basisende (242b) der Kontaktfläche (242a) und einem vorderen Ende (23a) des Abstandsvorsprungsbereichs (23) festgelegt ist, und auch der Durchmesser (D1) der Verbinderverriegelungsöffnung (14) so festgelegt ist, dass eine Überstandslänge (P1) des Lötanschlusses (21) ausgehend von der Durchgangsbohrung (11) einem Sollwert durch Kontakt zwischen der leiterplattenrückseitigen Kante (14a) der Verbinderverriegelungsöffnung (14) und der Kontaktfläche (242a) angepasst ist, wobei
eine Verbindung zwischen der gedruckten Leiterplatte (10) und dem Leiterplattenverbinder (20) in einer Richtung ausgeführt wird, in der der Leiterplattenverbinder (20) von der gedruckten Leiterplatte (10) nach unten hängt, und
der Leiterplattenverbinder (20) und die gedruckte Leiterplatte (10) in einen verbundenen Zustand gebracht werden, indem der Lötanschluss (21) mit der Durchgangsbohrung (11) in einem Aufschmelzverfahren verlötet wird, in welchem die Durchgangsbohrung (11) mit Lotpaste gefüllt wird, bevor der Lötanschluss (21) durch die Durchgangsbohrung (11) eingeführt wird.

3. Verfahren zum Verbinden des Leiterplattenverbinders (20) nach Anspruch 2, wobei ein Abstandswert, der eine Größe des Spalts zwischen der gedruckten Leiterplatte (10) und dem Gehäusekörper (22) angibt, auf einen Sollwert eingestellt wird, indem der Durchmesser der Verbinderverriegelungsöffnung (14) geändert wird.

## Revendications

1. Structure de raccordement d'un connecteur de carte (20) à une carte de circuit imprimé (10), le connecteur de la carte (20) comprenant:
une borne de soudure (21) configurée pour être soudée à un trou traversant (11) de la carte de circuit imprimé (10) ;
un corps de boîtier (22) configuré pour maintenir la borne de soudure (21) de sorte que la borne de soudure (21) fait saillie d'une longueur prédéterminée à partir de la carte de circuit imprimé (10);
une partie saillante de sécurité (23) prévue sur le corps de boîtier (22) pour faire saillie à partir du corps de boîtier (22) et configurée pour venir en butée sur la carte de circuit imprimé (10) lorsque le corps de boîtier (22) est fixé à la carte de circuit imprimé (10), pour ainsi produire un espace entre la carte de circuit imprimé (10) et le corps de boîtier (22) ; et une pièce de blocage élastique (24) comprenant une partie saillante de verrouillage (242) qui fait saillie dans une direction orthogonale à une direction d'épaisseur de la carte de circuit imprimé (10) et qui est prévue à une pointe d'extrémité d'une pièce élastique (241) s'étendant dans la direction de l'épaisseur de la carte de circuit imprimé (10) à partir du corps de boîtier (22),
dans lequel la partie saillante de verrouillage (242) s'engage avec un bord latéral (14a), au dos de la carte, d'une ouverture de verrouillage de connecteur (14) formée pour pénétrer à travers la carte de circuit imprimé (10) et pour permettre l'introduction de la pièce élastique (241) à travers l'ouverture de verrouillage de connecteur (14), empêchant ainsi le connecteur la carte (20) de tomber de la carte de circuit imprimé (10), dans lequel le connecteur de carte (20) est mis dans un état dans lequel le connecteur de carte (20) est raccordé à la carte de circuit imprimé (10) par engagement de la pièce de verrouillage élastique (24) avec le bord latéral (14a), au dos de la carte, de l'ouverture de verrouillage de connecteur (14),
**caractérisé en ce que**
une surface de contact (242a) de la partie saillante de verrouillage (242) configurée pour être mise en contact avec le bord latéral (14a), au de la carte, de l'ouverture de verrouillage de connecteur (14) est formée pour constituer une surface inclinée sur laquelle la carte de circuit imprimé (10) se déplace dans une direction dans laquelle la carte de circuit imprimé (10) s'éloigne du connecteur de carte (20) en cas d'augmentation d'un diamètre (D1) de l'ouverture de verrouillage de connecteur (14), et l'on utilise la carte de circuit imprimé (10), dont l'épaisseur (T1) doit être inférieure à une distance de séparation (S1) entre une extrémité de base (242b) de la surface de contact (242a) et une pointe d'extrémité (23a) de la partie saillante de sécurité (23), et de même le diamètre (D1) de l'ouverture de verrouillage de connecteur (14) est réglé de sorte qu'une longueur en saillie (P1) de la borne de soudure (21) à partir du trou traversant (11) corresponde à une valeur cible par contact entre le bord latéral (14a), au dos de la carte, de l'ouverture de verrouillage de connecteur (14) et la surface de contact (242a).

2. Procédé de raccordement d'un connecteur de carte (20) à une carte de circuit imprimé (10), dans lequel,
dans une structure de raccordement du connecteur de carte (20), le connecteur de carte (20) comprend:
une borne de soudure (21) configurée pour être soudée à un trou traversant (11) de la carte de circuit imprimé (10);
un corps de boîtier (22) configuré pour maintenir la borne de soudure (21) de sorte que la borne de soudure (21) fait saillie d'une longueur prédéterminée à partir de la carte de circuit imprimé (10);
une partie de projection de sécurité (23) prévue sur le corps de boîtier (22) pour faire saillie à partir du corps de boîtier (22) et configurée pour venir en butée sur la carte de circuit imprimé (10) lorsque le corps de boîtier (22) est fixé à la carte de circuit imprimé (10), pour ainsi produire un espace entre la carte de circuit imprimé (10) et le corps de boîtier (22); et une pièce de blocage élastique (24) comprenant une partie saillante de verrouillage (242) qui fait saillie dans une direction orthogonale à une direction d'épaisseur de la carte de circuit imprimé (10) et qui est prévue à une pointe d'extrémité d'une pièce élastique (241) s'étendant dans la direction de l'épaisseur de la carte de circuit imprimé (10) à partir du corps de boîtier (22), dans lequel la partie saillante de verrouillage (242) s'engage avec un bord latéral (14a), au dos de la carte, d'une ouverture de verrouillage de connecteur (14) formée pour pénétrer à travers la carte de circuit imprimé (10) et pour permettre l'introduction de la pièce élastique (241) à travers l'ouverture de verrouillage de connecteur (14), empêchant ainsi le connecteur la carte (20) de tomber de la carte de circuit imprimé (10), dans lequel le connecteur de carte (20) est mis dans un état dans lequel le connecteur de carte (20) est raccordé à la carte de circuit imprimé (10) par engagement de la pièce de verrouillage élastique (24) avec le bord latéral (14a), au dos de la carte, de l'ouverture de verrouillage de connecteur (14),
**caractérisé en ce que**
une surface de contact (242a) de la partie saillante de verrouillage (242) configurée pour être mise en contact avec le bord latéral (14a), au de la carte, de l'ouverture de verrouillage de connecteur (14) est formée pour constituer une surface inclinée sur laquelle la carte de circuit imprimé (10) se déplace dans une direction dans laquelle la carte de circuit imprimé (10) s'éloigne du connecteur de carte (20) en cas d'augmentation d'un diamètre (D1) de l'ouverture de verrouillage de connecteur (14), et
l'on utilise la carte de circuit imprimé (10), dont l'épaisseur (T1) doit être inférieure à une distance de séparation (S1) entre une extrémité de base (242b) de la surface de contact (242a) et une pointe d'extrémité (23a) de la partie saillante de sécurité (23), et de même le diamètre (D1) de l'ouverture de verrouillage de connecteur (14) est réglé de sorte qu'une longueur en saillie (P1) de la borne de soudure (21) à partir du trou traversant (11) corresponde à une valeur cible par contact entre le bord latéral (14a), au dos de la carte, de l'ouverture de verrouillage de connecteur (14) et la surface de contact (242a), dans lequel
le raccordement entre la carte de circuit imprimé (10) et le connecteur de carte (20) est réalisé dans une direction dans laquelle le connecteur de carte (20) est suspendu à partir de la carte de circuit imprimé (10), et
le connecteur de carte (20) et la carte de circuit imprimé (10) sont mis dans un état connecté par soudage de la borne de soudure (21) au trou traversant (11) selon un procédé de refusion dans lequel le trou traversant (11) est rempli de pâte de soudure avant l'introduction de la borne de soudage (21) à travers le trou traversant (11).

3. Procédé de raccordement du connecteur de carte (20) selon la revendication 2, dans lequel une valeur de sécurité, qui indique une taille de l'espace entre la carte de circuit imprimé (10) et le corps de boîtier (22), adopte alors une valeur désirée en changeant le diamètre de l'ouverture de verrouillage de connecteur (14).
